# EUROPEAN PATENT SPECIFICATION

(11) **EP 3 217 436 B1**
(45) Date of publication and mention of the grant of the patent: **30.12.2020**
(21) Application number: 15856987.1
(22) Date of filing: 12.08.2015
(51) Int. Cl.: H01L 29/872, H01L 21/20, H01L 21/205, H01L 21/329, H01L 29/26

(54) **SEMICONDUCTOR DEVICE AND PRODUCTION METHOD THEREFOR**
HALBLEITERBAUELEMENT UND HERSTELLUNGSVERFAHREN DAFÜR
DISPOSITIF À SEMI-CONDUCTEUR ET PROCÉDÉ DE FABRICATION ASSOCIÉ

(30) Priority: 04.11.2014 JP 2014224076
(43) Date of publication of application: 13.09.2017
(73) Proprietor: Air Water Inc., Sapporo-shi Hokkaido 060-0003 (JP)
(72) Inventor: FUKAZAWA, Akira, Matsumoto-shi, Nagano 390-1701 (JP); OUCHI, Sumito, Matsumoto-shi, Nagano 390-1701 (JP)
(74) Representative: Hering, Hartmut
(86) International application number: PCT/JP2015/072863
(87) International publication number: WO 2016/072122

(56) References cited:
- EP-A2- 1 947 700
- JP-A- 2007 036 010
- JP-A- 2007 036 010
- JP-A- 2009 081 269
- JP-A- 2013 179 121
- JP-A- 2014 076 925
- JP-A- 2014 076 925
- US-A1- 2006 138 448
- KOMIYAMA JUN ET AL: "Suppression of crack generation in GaN epitaxy on Si using cubic SiC as intermediate layers", APPLIED PHYSICS LETTERS, A I P PUBLISHING LLC, US, vol. 88, no. 9, 27 February 2006 (2006-02-27), pages 91901-091901, XP012083062, ISSN: 0003-6951, DOI: 10.1063/1.2175498

## Description

### Field of the Invention

This invention relates to a semiconductor device and a method for manufacturing the same. More specifically, this invention relates to a semiconductor device including an SiC (silicon carbide) layer and a method for manufacturing the same.

### Description of the Related Art

SiC has a wide band gap when compared to Si (silicon), and has high insulated breakdown field strength. Therefore, SiC is expected to serve as material of high-voltage semiconductor devices. Since the lattice constant of 3C-SiC (SiC which has a 3C type crystal structure) is similar to the lattice constant of GaN (gallium nitride), 3C-SiC can be used as a buffer layer for growing GaN. Since the insulated breakdown field strength of GaN is higher than the insulated breakdown field strength of SiC, higher-voltage semiconductor devices of GaN can be obtained by adopting 3C-SiC as a buffer layer.

As a foundation substrate for growing an SiC layer, Si substrates, or bulk SiC substrates are widely used. Since there are only about 4 inch SiC substrates at present, it is difficult to increase the diameter. To obtain an inexpensive and large diameter SiC layer, it is preferable that an Si substrate is used as the foundation substrate.

A conventional semiconductor device which includes GaN is disclosed in the Document 1 below, for example. The Document 1 below discloses a semiconductor device comprising a Si substrate, a buffer layer formed on the Si substrate, an n-type semiconductor layer which consists of GaN formed on the buffer layer, an active layer which consists of InGaN (indium gallium nitride) formed on the n-type semiconductor layer, a p-type semiconductor layer which consists of GaN formed on the active layer, an anode electrode formed on the p-type semiconductor layer, and a cathode electrode formed on the Si substrate. In the buffer layer, first layers which consist of AlN (aluminum nitride) and second layers which consist of GaN are alternately stacked.

The Documents 2 and 3 below disclose a method for forming a GaN layer on a SiC layer. The Document 2 discloses a method for manufacturing a semiconductor substrate comprising a first step for forming a film of AlₓIn_{y}Ga_{1-x-y}N(0 < x ≦ 1, 0 ≦ y ≦ 1, x+y ≦ 1) layer on SiC under a temperature higher than the temperature of forming a GaN film and after that forming a film of GaN under the temperature of forming a GaN film, and a second step for forming a film of an AlₓIn_{y}Ga_{1-x-y}N(0 < x ≦ 1, 0 ≦ y ≦ 1, x+y ≦ 1) layer under a temperature lower than the temperature of forming the GaN film and after that forming a film of GaN under the temperature of forming the GaN film.

The Document 3 discloses a method for manufacturing a semiconductor substrate comprising a step for preparing an Si substrate on which a SiC single-crystal thin film of which the film thickness is more than or equal to 2nm and equal to or less than 3.5µm was formed on the surface, and forming a buffer layer composed of at least 2 components among Al, In, Ga, and N by heating the Si substrate on which the SiC single-crystal thin film was formed to a predetermined growth temperature, a step for forming three-dimensional nuclei of GaN crystals on the buffer layer under a temperature lower than the growth temperature of the buffer layer, so that the nuclei have a predetermined density, and a step for growing the three-dimensional nuclei of the GaN crystals in a horizontal direction at a temperature lower than the growth temperature of the buffer layer so that a continuous GaN single-crystal film is formed. The film thickness of the buffer layer is less than 15nm, and the composition is AlₓIn_{y}Ga_{1-x-y}N (0.05 ≦ x ≦ 1, 0 ≦ y ≦ 0.5, x+y ≦ 1).

### Prior art document(s)

### Patent document(s)

[Patent Document 1]: Japan Patent Publication No. 2003-60234
[Patent Document 2]: Japan Patent Publication No. 2013-179121
[Patent Document 3]: Japan Patent Publication No. 2014-76925

US 2006/138448 A1 discloses that In_{y}Ga_{z}N single crystal layer has an n-type conductivity and a material containing Si can be used as the n-type dopant.

In a specific embodiment, it is disclosed a Schottky diode comprising a bottom electrode, a Si conductive layer, an SiC layer, an AlN buffer layer, a GaN layer and a Schottky electrode stacked in this order over each other.

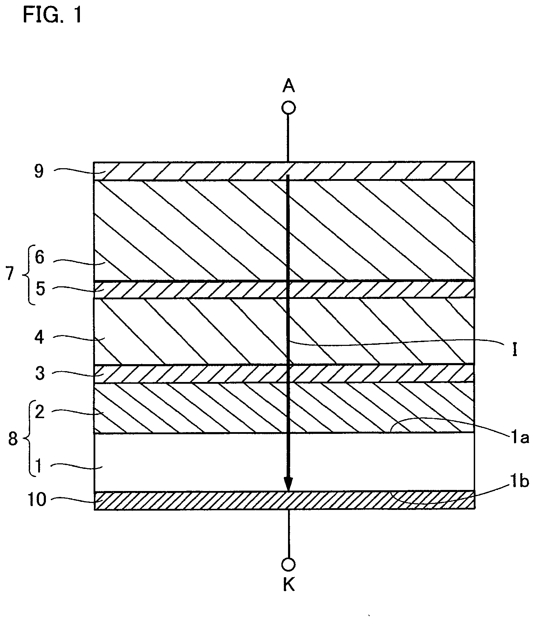

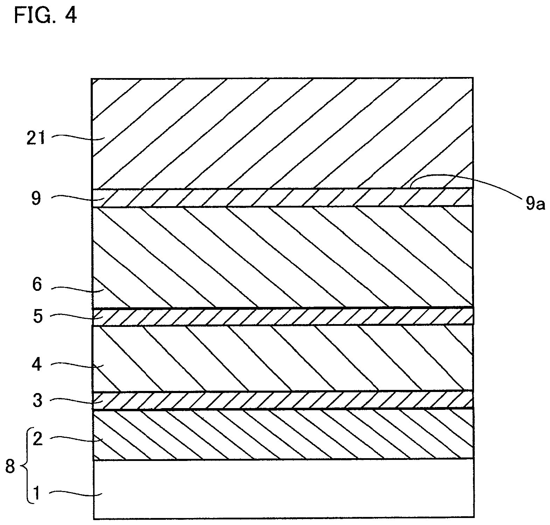

KOMIYAMA JUN ET AL: "Suppression of crack generation in GaN epitaxy on Si using cubic SiC as intermediate layers", APPLIED PHYSICS LETTERS, A I P PUBLISHING LLC, US, vol. 88, no. 9,27.02.2006, pages 91901-091901, XP012083062, ISSN: 0003-6951, DOI; 10.1063/1.2175498 discloses in fig. 1 a prepared sample including a Si substrate, a 3C-SiC intermediate layer, an AlN layer and a GaN layer. In fig. 4 there is disclosed a structure in which electrodes are provided at each of upper side and lower side of the prepared sample, illustrating how to a measure current-voltage property of the prepared sample.

JP 2014 076925 A discloses in fig. 5 a composite layer including an AlN intermediate layer having a thickness of 12 nm and a GaN layer having a thickness of 1 µm - 2 µm, while silicon atoms are doped neither in the AlN intermediate layer nor in the GaN layer.

JP2007 036010 A discloses in fig. 4 a structure including a Si substrate, a first buffer layer composed of an AlN, a second buffer layer composed of a GaN, an n+-type GaN layer, and an n--type GaN layer.

EP 1947700 A2 discloses in fig. 1 a Schottky diode 100 including a substrate 102 made of metallized silicon, a metal bonding layer 104, a Schottky metal layer 106, an AlGaN buffer layer 108, a GaN layer 110, an n+GaN buffer layer 112, and an ohmic contact 114.

JP 2013 179121 A discloses in fig.3 a composite layer including an AlN layer and a GaN layer, while the GaN layer does not have an n-type conductivity, and a silicon is not doped in the GaN layer.

### The overview of the invention

### Problems to be resolved by the invention

When producing a semiconductor device which includes an upright device by using a GaN layer, the conventional technique has a problem of high electrical resistance in the longitudinal direction (in a direction perpendicular to the substrate surface) and large power consumption.

This invention is to solve the above problems, and the object is to provide a semiconductor device and a method for manufacturing the same which can reduce the power consumption.

### SUMMARY OF THE INVENTION

According to this invention, the problem is solved by a semiconductor device as described in independent claim 1 as well as a method for manufacturing a semiconductor device as described in independent claim 6. The dependent claims 2 to 5 and 7 to 9 describe advantageous further developments of the present invention.

### The Effect of the Invention

According to this this invention, a semiconductor device and a method for manufacturing the same which can reduce the power consumption can be provided.

### BRIEF DESCRIPTION OF THE DRAWINGS

[Figure 1] shows a cross sectional view indicating a structure of the semiconductor device according to the first embodiment of this invention.
[Figure 2] shows a cross sectional view indicating a structure of the semiconductor device according to an example not forming part of this invention.
[Figure 3] shows a cross sectional view indicating the first step of the method for manufacturing the semiconductor device according to the device of Figure 2.
[Figure 4] shows a cross sectional view indicating the second step of the method for manufacturing the semiconductor device of Figure 2.
[Figure 5] shows a cross sectional view indicating the third step of the method for manufacturing the semiconductor device of Figure 2.
[Figure 6] shows a cross sectional view indicating the fourth step of the method for manufacturing the semiconductor device of Figure 2.

### DESCRIPTION OF THE PREFERRED EMBODIMENTS

The embodiments of this invention will be explained in the followings based on the Figures. In the following explanations, a "surface" of each of layers which constitute a semiconductor device is a term to represent an upper side face in Figures, and a "reverse face" is a term to represent a lower side face in Figures. The term of "being formed on a surface" means being formed making contact with the surface, and the term of "being formed on a reverse face" means being formed making contact with the reverse face. The term of a "surface side" encompasses a location making contact with the "surface" and an upper location in Figures being separated from the "surface". The term of a "reverse face side" encompasses a location making contact with the "reverse face" and a lower location in Figures being separated from the "reverse face".

### [The first embodiment]

Figure 1 shows a cross sectional view indicating a structure of the semiconductor device according to the first embodiment of this invention.

Referring to Figure 1, the semiconductor device according to this embodiment includes a schottky barrier diode. The semiconductor device is equipped with Si substrate 1, SiC layer 2, AlN layer 3, GaN layer 4, AlN layer 5, GaN layer 6, and electrodes 9 and 10.

Si substrate 1 (an example of an electrical conductor layer) comprises of n-type Si. Si substrate 1 has surface 1a and reverse face 1b. The surface 1a of Si substrate 1 consists of a (111) plane of a Si crystal.

SiC layer 2 is formed on surface 1a of Si substrate 1. SiC layer 2 comprises of, for example, 3C-SiC, 4H-SiC, 6H-SiC, or the like. In particular, when SiC layer 2 was grown epitaxially on Si substrate 1, SiC layer 2 is typically formed by 3C-SiC. The thickness of SiC layer 2 is, for example, more than or equal to 2nm and equal to or less than 3.5µm.

SiC layer 2 may be formed by homoepitaxial growth of SiC by using the MBE (molecular beam epitaxy) method, the CVD (chemical vapor deposition) method, the LPE (liquid-phase epitaxy) method, or the like, on a foundation layer comprised of SiC which was made by carbonizing the surface of Si substrate 1. SiC layer 2 may be formed by only carbonizing the surface of Si substrate 1. SiC layer 2 may be formed by heteroepitaxial growth of SiC on the surface of Si substrate 1 interposing a buffer layer.

AlN layer (HT (High Temperature) - AlN layer) 3 is formed on the surface of SiC layer 2. AlN layer 3 has a function as a buffer layer which alleviates a gap between the lattice constant of SiC layer 2 and the lattice constant of GaN layer 4. AlN layer 3 is formed by using the MOCVD (Metal Organic Chemical Vapor Deposition) method, for example. The growth temperature of AlN layer 3 is more than or equal to 1100 degree Celsius and is equal to or less than 1300 degree Celsius, for example. The film forming temperature of AlN layer 3 is arbitrary, and may be the same level of the film forming temperature of GaN layer 4 which will be explained later. However, the film forming temperature of AlN layer 3 is preferably higher than the film forming temperature of GaN layer 4 which will be explained later. The growth temperature of AlN layer 3 is more than or equal to 1100 degree Celsius and is equal to or less than 1300 degree Celsius, for example. At this time, TMA (Tri Methyl Aluminium), TEA (Tri Ethyl Aluminium), or the like is used as Al source gas, for example. As N source gas, NH₃ (ammonia) is used, for example. The thickness of AlN layer 3 is preferably larger than 0 and equal to or less than 15nm. Herewith, dislocation formed in AlN layer 3 can be reduced, and crystallinity of GaN layer 4 can be improved. In addition, time required for forming AlN layer 3 can shorten.

In examples not forming part of the invention, AlN layer 3 may be an AlₓGa₁₋ₓN (0 < x ≦ 1) layer, by replacing part of Al atoms with Ga atoms. However, to maintain crystallinity of GaN layer 4, the AlₓGa₁₋ₓN layer is AlN (in which Al atoms do not replaced with Ga atoms).

GaN layer 4 is formed on the surface of AlN layer 3. GaN layer 4 is doped with Si, and the conductivity type is n-type. The thickness of GaN layer 4 is preferably more than or equal to 50nm and equal to or less than 5µm. The thickness of GaN layer 4 is more preferably more than or equal to 200 nm and equal to or less than 2µm. Herewith, warpage of the substrate can be inhibited, and a high quality GaN layer can be obtained.

GaN layer 4 is formed by using the MOCVD method in the following manner, for example. Firstly, three-dimensional nuclei of GaN crystal are formed at predetermined density. Next, the three-dimensional nuclei of GaN crystal are grown in the horizontal direction at a temperature lower than the growth temperature of AlN layer 3 to form a continuous GaN single-crystal film. At this time, as Ga source gas, TMG (Tri Methyl Gallium), TEG (Tri Ethyl Gallium), or the like is used, for example. As N source gas, NH₃ is used, for example. As Si source gas, for example, SiH₄ (silane) is used. As such the method, by doping the forming film of GaN layer 4 with Si, n-type GaN layer 4 can be made simply.

The process temperature (the film forming temperature of GaN layer 4) in the step for forming the three-dimensional nuclei, and the step for growing the three-dimensional nuclei of GaN crystals in the horizontal direction is more than or equal to 900 degree Celsius and equal to or less than 1200 degree Celsius, for example.

In examples not forming part of the invention, GaN layer 4 may be Al_{y}Ga_{1-y}N layer (0 ≦ y < 1, y < x, preferably y ≦ 0.2, more preferably y ≦ 0.1) by replacing part of Ga atoms with Al atoms. However, to maintain crystallinity of GaN layer 4, the Al_{y}Ga_{1-y}N layer is GaN (in which Ga atoms do not replaced with Al atoms).

AlN layer (LT (Low Temperature) - AlN layer) 5 is formed on the surface of GaN layer 4. AlN layer 5 has a function as an intermediate layer to suppress warpage of the substrate, maintaining crystallinity of GaN. AlN layer 5 is formed by using the MOCVD method, for example. The growth temperature of AlN layer 5 is lower than the film forming temperature of GaN layers 4 and 6 The thickness of AlN layer 5 is preferably larger than 0 and equal to or less than 20nm. The thickness of AIN layer 5 is more preferably equal to or less than 15nm.

AlN layer 5 may be an AlₘGa₁₋ₘN (0 < m ≦ 1, y < m) layer by replacing part of Al atoms with Ga atoms. However, to maintain crystallinity of GaN layer 6, the AlₘGa₁₋ₘN layer is preferably AlN (in which Al atoms are not replaced with Ga atoms). The value of x may be same as the value of m, and the value of x may be different from the value of m.

GaN layer 6 is formed on the surface of AlN layer 5. GaN layer 6 is doped with Si, and has n-type conductivity. GaN layer 6 is formed in a manner similar to that of GaN layer 4, at the similar film forming temperature. The thickness of GaN layer 6 is preferably more than or equal to 50nm and equal to or less than 5µm. The Si dope density of GaN layer 6 is different from that of GaN layer 4, based on types of the device to be manufactured.

In examples not forming part of the invention, GaN layer 6 may be an AlₙGa₁₋ₙN layer (0 ≦ n < 1, n < x, n < m) by replacing part of Ga atoms with Al atoms. However, to maintain crystallinity of GaN layer 6, the AlₙGa₁₋ₙN layer is GaN (in which Ga atoms are not replaced with Al atoms). The n-type impurity concentration of GaN layer 6 is lower than the n-type impurity concentration of GaN layer 4. The n-type impurity concentration of an upper part of GaN layer 6 is lower than the n-type impurity concentration of the lower part of GaN layer 6. The value of y may be same as the value of n, and the value of y may be different from the value of n.

AlN layer 5 and GaN layer 6 constitute composite layer 7. The number of composite layers formed at the surface side of GaN layer 4 is arbitrary (one layer in this embodiment), and is preferably more than or equal to 1 and equal to or less than 4. When a plurality of composite layers are stacked and formed, electrode 9 is formed at the surface side of GaN layer 6 furthest from SiC layer 2 in the composite layers. The value of m or n of each of layers in the plurality of composite layers may be different from each other.

Electrode 9 is an anode electrode, and is formed on the surface of GaN layer 6. Electrode 9 is placed in schottky contact with GaN layer 6. Electrode 9 is made of Au (gold), for example. Electrode 9 is formed by the deposition method, the MOCVD method, the sputtering method, or the like, for example.

Electrode 10 is a cathode electrode, and formed on the reverse face 1b of Si substrate 1. Electrode 10 is made of Al or the like, for example. Electrode 10 is formed by the deposition method, the MOCVD method, the sputtering method, or the like, for example.

The semiconductor device according to this embodiment works as follows. In a state in which electrode 10 is grounded, when positive electrical potential is applied to electrode 9, electrical current I flows from electrode 9 to electrode 10. Since AlN layers 3 and 5 are thin, electrons can pass through each of AlN layers 3 and 5 by the tunneling effect. The magnitude of electrical current I depends on electrical voltage between electrode 9 and electrode 10.

The semiconductor device according to this embodiment is manufactured in the following manner. The structure (substrate) 8 which includes Si substrate 1 and SiC layer 2 is prepared. AlN layer 3 is formed on the surface of SiC layer 2. The film of GaN layer 4 is formed on the surface of AlN layer 3 at a temperature lower than the film forming temperature of AlN layer 3. AlN layer 5 is formed on the surface of GaN layer 4. The film of GaN layer 6 is formed on the surface of AlN layer 5 at a temperature lower than the film forming temperature of AlN layer 5. Electrode 9 is formed on the surface of GaN layer 6 (at the surface side of AlN layer 3). Electrode 10 is formed at the reverse face 1b of Si substrate 1 (at the reverse face side of AlN layer 3).

The lattice constant of AlN is insignificantly smaller than the lattice constant of GaN. Therefore, when GaN layer 4 is formed on the foundation AlN layer 3 according to this embodiment, since GaN layer 4 is subject to the compression stress, the occurrence of cracks in GaN layer 4 can be avoided. Herewith, GaN layer 4 of the high quality crystal can be obtained, and the electrical resistance of GaN layer 4 can be reduced. On the other hand, AlN layer 3 has high electrical resistance when compared to other layers. According to this embodiment, by forming AlN layer 3 on SiC layer 2, the thickness of AlN layer 3 can be reduced, keeping the high quality of the crystal of GaN layer 4 formed on the surface of AlN layer 3. In consequence, since the electrical resistance between electrode 9 and electrode 10 is reduced, the power consumption of the semiconductor device can be reduced. By forming SiC layer 2 on Si substrate 1, inexpensive and large diameter semiconductor devices can be obtained. Further, by forming SiC layer 2 on Si substrate 1, when AlN layer 3 is thinned, the occurrence of defect by melt back etching caused by the reaction of Ga with Si can be prevented.

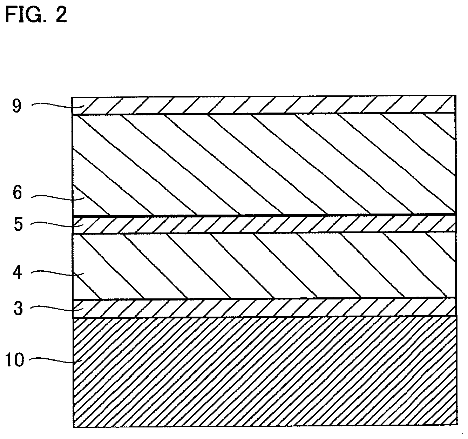

Figure 2 shows a cross sectional view indicating a structure of the semiconductor device according to an example not forming part of this invention.

Referring to Figure 2, the structure of the semiconductor is different from the structure of the semiconductor device according to the first embodiment, in that the Si substrate and the SiC layer are removed. Electrode 10 is formed on the reverse face side of AlN layer 3. Electrode 10 and AlN layer 3 may make directly contact with each other, or electrode 10 and AlN layer 3 may be placed interposing an arbitrary electrical conductor.

Since the structures of the semiconductor device according to this example other than the above mentioned are similar to the structures of the semiconductor device according to the first embodiment, the same numerals are provided for same components, and the explanations are not repeated.

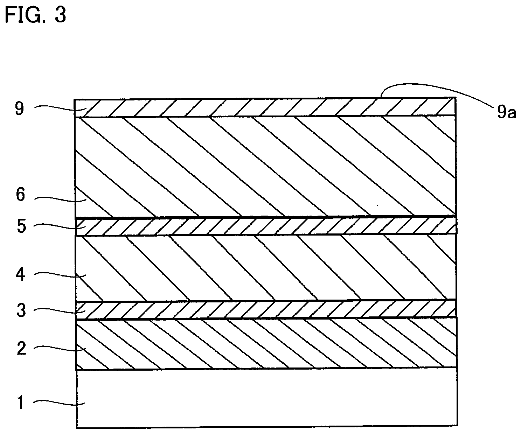

Next, by using Figure 3 to Figure 6, the method for manufacturing the semiconductor device according to the example will be explained.

Referring to Figure 3, Si substrate 1, SiC layer 2, AlN layer 3, GaN layer 4, AlN layer 5, GaN layer 6, and electrode 9 are formed in a manner similar to the manufacturing method of the first embodiment. When resist is formed on the surface 9a of electrode 9 during patterning electrode 9, the resist is preferably not removed and maintained as a protective film.

Referring to Figure 4, supporting substrate 21 is stuck on the surface 9a of electrode 9, by using an adhesive agent such as electron wax. Supporting substrate 21 comprises of Si, SiC, or the like, for example.

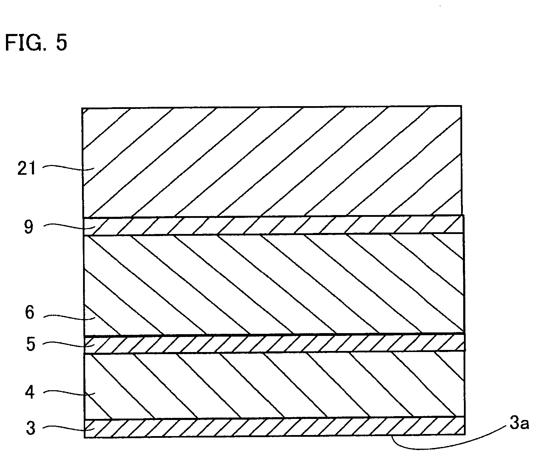

Referring to Figure 5, Si substrate 1 is removed by wet etching using hot nitric acid, boiling nitric acid, or the like, for example. Next, SiC layer 2 is removed by dry etching or the like. Herewith, substrate 8 is removed, and reverse face 3a of AlN layer 3 is exposed. SiC layer 2 may be not removed and be maintained. Substrate 8 may be removed, after AlN layer 3 and GaN layer 4 were formed. Further, maintaining the GaN layer farthest from substrate 8 (the GaN layer uppermost in the Figures), all the layers formed at the reverse face side of the maintained GaN layer may be removed.

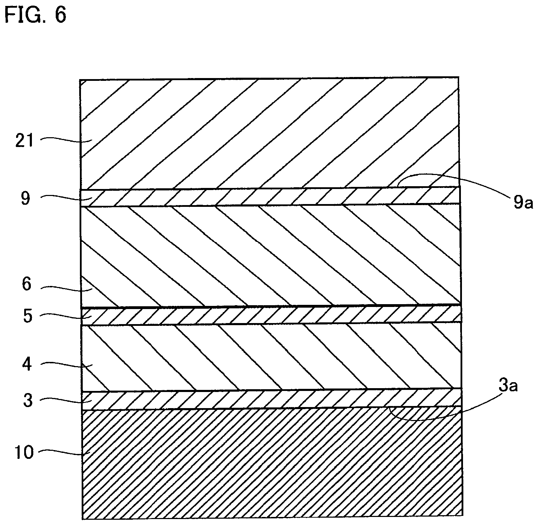

Referring to Figure 6, electrode 10 is stuck on the reverse face 3a of AlN layer 3 (on the reverse face of SiC layer 2 when the SiC layer was maintained, or on the reverse face of the GaN layer farthest from substrate 8 when all the layers formed at the reverse face side of the GaN layer farthest from substrate 8 were removed), by using an electric conductive adhesive agent such as Ag (silver) paste or the like. Next, supporting substrate 21 is removed by heating, for example. Next, the adhesive agent and the protective film which remain on the surface 9a of electrode 9 are removed by using solvent such as acetone, for example. As described above, the semiconductor device shown in Figure 2 can be obtained. A substrate of which the electric conductivity is higher than that of substrate 1 can be stuck as electrode 10.

According to the example of Figure 2, the effect similar to the first embodiment can be acquired. In addition, it is possible to reduce the thickness of the semiconductor device and to reduce the electrical resistance in the longitudinal direction, since the thicknesses of the Si substrate and the SiC layer are eliminated from the thickness of the semiconductor device.

### [Others]

The thickness of each of layers which constitute the semiconductor device is measured by using a spectroscopic ellipsometer. A spectroscopic ellipsometer irradiates an object to be measured with incident light which is polarized light, and receives the reflected light from the object to be measured. Since there is a difference in phase shift and reflectance between S polarized light and P polarized light, the polarized light state of the reflected light is different from the polarized light state of the incident light. The change of the polarized light state depends on the wavelength of the incident light, the incident angle, the optical constant value of the film, the film thickness, and so on. The spectroscopic ellipsometer calculates the optical constant value and the film thickness of the film from the acquired reflected light, based on the wavelength of the incident light and the incident angle.

In the above mentioned embodiment and example an electrical conductor layer may be a layer other than the Si substrate. The electrical conductor layer may be made of metal such as Cu (copper) and Al, or an electric conductive semiconductor layer such as GaAs (gallium arsenide), Ge(germanium), and Si, for example.

In examples not forming part of the invention, AlN layer 5 and GaN layer 6 may be omitted, and electrode 9 may be directly formed on the surface of GaN layer 4. In this case, the manufacturing process can be simplified, and the semiconductor device can have a simple structure. At the surface side of GaN layer 6, an AlN layer and a GaN layer may be further stacked. In this case, the quality of the crystal of the GaN layer can be improved.

The device formed on the semiconductor device may be an arbitrary upright device. In examples not forming part of the invention, It may be a MOSFET, an LED (Light Emitting Diode), a thyristor, a semiconductor laser, or the like, other than the above described schottky barrier diode. The semiconductor device may be any device as long as the magnitude of electrical current which flows between the first electrode formed at the surface side of the GaN layer 6 layer and the second electrode formed at the reverse face side of the Si substrate depends on the electrical voltage between the first electrode and the second electrode.

Although the present invention has been described and illustrated in detail, it is clearly understood that the same is by way of illustration and example only and is not to be taken by way of limitation, the scope of the present invention being limited only by the terms of the appended claims.

### [The explanation of the referential numerals]

- 1: Si (silicon) substrate
- 1a: The surface of the Si substrate
- 1b: The reverse face of the Si substrate
- 2: SiC (silicon carbide) layer
- 3, 5: AlN (aluminum nitride) layers
- 3a: The reverse face of the AlN layer
- 4, 6: GaN (gallium nitride) layer
- 7a, 7b: Composite layers
- 8: The structure (substrate) which includes the Si substrate and the SiC layer
- 9, 10: Electrodes
- 9a: The surface of the electrode
- 21: Supporting substrate
- I: Electrical current

## Claims

1. A semiconductor device comprising:
an electrical conductor layer (1),
an SiC layer (2) formed on a surface of the electrical conductor layer,
an AIN layer (3) formed on a surface of the SiC layer (2), a thickness of the AIN layer is larger than 0 and equal to or less than 15 nm,
a first GaN layer (4) of a first conductivity type, formed on a surface of the AIN layer,
a composite layer (7) formed on a surface of the first GaN layer,
a first electrode (9) formed at a surface side of the first GaN layer, and
a second electrode (10) formed on a reverse face side of the electrical conductor layer, wherein
the magnitude of electrical current which flows between the first electrode and the second electrode depends on the electrical voltage between the first electrode and the second electrode,
the composite layer includes an AlₘGa₁₋ₘN (0 < m ≦ 1, y < m) layer (5), and a second GaN layer (6) formed on a surface of the AlₘGa₁₋ₘN layer,
a distance between the first electrode and the electrical conductor layer is larger than a distance between the second GaN layer and the electrical conductor layer, the first electrode is placed in Schottky contact with the second GaN layer,
each of the first GaN layer and the second GaN layer has n-type conductivity, and each of the first GaN layer and the second GaN layer is doped with Si,
a Si dope density of the second GaN layer is different from a Si dope density of the first GaN layer,
an n-type impurity concentration of the second GaN layer is lower than an n-type impurity concentration of the first GaN layer, and
the n-type impurity concentration of an upper part of the second GaN layer is lower than the n-type impurity concentration of the lower part of the
second GaN layer.

2. The semiconductor device according to claim 1, wherein
thickness of each of the first GaN layer and the second GaN layer is more than or equal to 50 nm and equal to or less than 5 µm.

3. The semiconductor device according to claim 1, wherein
thickness of the AlₘGa₁₋ₘN layer is more than 0 and equal to or less than 15 nm.

4. The semiconductor device according to claim 1, the device comprising a plurality of composite layers, wherein a number of the composite layers is more than 1 and equal to or less than 4 layers.

5. The semiconductor device according to claim 1, wherein
the electrical conductor layer is a Si substrate.

6. A method for manufacturing a semiconductor device comprising:
a step for preparing a substrate (8) which includes an electrical conductor layer (1) and an SiC layer (2) formed on a surface of the electrical conductor layer,
a step for forming a film of an AIN layer (3) on a surface of the SiC layer, a thickness of the AIN layer is larger than 0 and equal to or less than 15 nm,
a step for forming a film of a first GaN layer (4) of a first conductivity type on a surface of the AIN layer,
a step for forming a film of an AlₘGa₁₋ₘN (0 < m ≦ 1, y < m) layer (5) on a surface of the first GaN layer at a temperature lower than a film forming temperature of the first GaN layer,
a step for forming a film of a second GaN layer (6) on a surface of the AlₘGa₁₋ₘN layer at a temperature higher than a film forming temperature of the AlₘGa₁₋ₘN layer,
a step for forming a first electrode (9) at a surface side of the second GaN layer, the first electrode is placed in Schottky contact with the second GaN layer, and
a step for forming a second electrode (10) at a reverse face side of the second GaN layer, wherein
the magnitude of electrical current which flows between the first electrode and the second electrode depends on the electrical voltage between the first electrode and the second electrode,
the forming film of the first GaN layer is doped with Si, in the step for forming a film of the first GaN layer,
the forming film of the second GaN layer is doped with Si, in the step for forming a film of the second GaN layer,
each of the first GaN layer and the second GaN layer has n-type conductivity,
a Si dope density of the second GaN layer is different from a Si dope density of the first GaN layer, and
an n-type impurity concentration of the second GaN layer is lower than an n-type impurity concentration of the first GaN layer, and
the n-type impurity concentration of an upper part of the second GaN layer is lower than the n-type impurity concentration of the lower part of the second GaN layer.

7. The method for manufacturing a semiconductor device according to claim 6, further comprising
a step for removing the electrical conductor layer after films of the AIN layer, the first GaN layer, the AlₘGa₁₋ₘN layer, and the second GaN layer were formed, wherein
the second electrode is formed at a reverse face side of the second GaN layer, in the step for forming the second electrode, after the electrical conductor layer was removed.

8. The method for manufacturing a semiconductor device according to claim 7, wherein
the substrate is removed in the step for removing the electrical conductor layer.

9. The method for manufacturing a semiconductor device according to claim 8, wherein
all layers formed at a reverse face side of the second GaN layer are removed, maintaining the second GaN layer farthest from the substrate, in the step for removing the electrical conductor layer.

## Patentansprüche

1. Halbleitervorrichtung, die folgendes umfasst:
eine elektrische Leiterschicht (1),
eine SiC-Schicht (2), die auf einer Oberfläche der elektrischen Leiterschicht ausgebildet ist,
eine AlN-Schicht (3), die auf einer Oberfläche der SiC-Schicht (2) ausgebildet ist, wobei eine Dicke der AlN-Schicht größer als 0 und gleich oder kleiner als 15 nm ist,
eine erste GaN-Schicht (4) eines ersten Leitfähigkeitstyps, die auf einer Oberfläche der AlN-Schicht ausgebildet ist,
eine Verbundschicht (7), die auf einer Oberfläche der ersten GaN-Schicht ausgebildet ist,
eine erste Elektrode (9), die an einer Oberflächenseite der ersten GaN-Schicht ausgebildet ist, und
eine zweite Elektrode (10), die auf einer Rückseite der elektrischen Leitschicht ausgebildet ist, wobei
die Größe eines elektrischen Stroms, der zwischen der ersten Elektrode und der zweiten Elektrode fließt, von der elektrischen Spannung zwischen der ersten Elektrode und der zweiten Elektrode abhängt,
die Verbundschicht eine AlₘGa₁₋ₘN-(0 < m ≤ 1, y < m)Schicht (5) und eine auf einer Oberfläche der AlₘGa₁₋ₘN-Schicht ausgebildete zweite GaN-Schicht (6) enthält,
ein Abstand zwischen der ersten Elektrode und der elektrischen Leiterschicht größer als ein Abstand zwischen der zweiten GaN-Schicht und der elektrischen Leiterschicht ist, wobei die erste Elektrode in Schottky-Kontakt mit der zweiten GaN-Schicht angeordnet ist,
jede der ersten GaN-Schicht und der zweiten GaN-Schicht eine n-Typ-Leitfähigkeit hat und jede der ersten GaN-Schicht und der zweiten GaN-Schicht mit Si dotiert ist,
eine Si-Dotierungsmitteldichte der zweiten GaN-Schicht unterschiedlich von einer Si-Dotierungsmitteldichte der ersten GaN-Schicht ist,
eine n-Typ-Störstellenkonzentration der zweiten GaN-Schicht niedriger als eine n-Typ-Störstellenkonzentration der ersten GaN-Schicht ist, und
die n-Typ-Störstellenkonzentration eines oberen Teils der zweiten GaN-Schicht niedriger als die n-Typ-Störstellenkonzentration des unteren Teils der zweiten GaN-Schicht ist.

2. Halbleitervorrichtung nach Anspruch 1, wobei
eine Dicke von jeder der ersten GaN-Schicht und der zweiten GaN-Schicht größer als oder gleich 50 nm und gleich oder kleiner als 5 µm ist.

3. Halbleitervorrichtung nach Anspruch 1, wobei
eine Dicke der AlₘGa₁₋ₘN-Schicht größer als 0 und gleich oder kleiner als 15 nm ist.

4. Halbleitervorrichtung nach Anspruch 1, wobei die Vorrichtung eine Vielzahl von Verbundschichten umfasst, wobei
eine Anzahl der Verbundschichten mehr als 1 und gleich oder weniger als 4 Schichten ist.

5. Halbleitervorrichtung nach Anspruch 1, wobei
die elektrische Leiterschicht ein Si-Substrat ist.

6. Verfahren zum Herstellen einer Halbleitervorrichtung, das folgendes umfasst:
einen Schritt zum Vorbereiten eines Substrats (8), das eine elektrische Leiterschicht (1) und eine auf einer Oberfläche der elektrischen Leiterschicht ausgebildete SiC-Schicht (2) enthält,
einen Schritt zum Ausbilden eines Films einer AlN-Schicht (3) auf einer Oberfläche der SiC-Schicht, wobei eine Dicke der AlN-Schicht größer als 0 und gleich oder kleiner als 15 nm ist,
einen Schritt zum Ausbilden eines Films einer ersten GaN-Schicht (4) eines ersten Leitfähigkeitstyps auf einer Oberfläche der AlN-Schicht,
einen Schritt zum Ausbilden eines Films einer AlₘGa₁₋ₘN-(0 < m ≤ 1, y < m)Schicht (5) auf einer Oberfläche der ersten GaN-Schicht bei einer Temperatur, die niedriger als eine Filmausbildungstemperatur der ersten GaN-Schicht ist,
einen Schritt zum Ausbilden eines Films einer zweiten GaN-Schicht auf einer Oberfläche der AlₘGa₁₋ₘN-Schicht bei einer Temperatur, die niedriger als eine Filmausbildungstemperatur der AlₘGa₁₋ₘN-Schicht ist,
einen Schritt zum Ausbilden einer ersten Elektrode (9) an einer Oberflächenseite der zweiten GaN-Schicht, wobei die erste Elektrode in Schottky-Kontakt mit der zweiten GaN-Schicht angeordnet ist, und
einen Schritt zum Ausbilden einer zweiten Elektrode (10) an einer Rückseite der zweiten GaN-Schicht, wobei
die Größe eines elektrischen Stroms, der zwischen der ersten Elektrode und der zweiten Elektrode fließt, von der elektrischen Spannung zwischen der ersten Elektrode und der zweiten Elektrode abhängt,
im Schritt zum Ausbilden eines Films der ersten GaN-Schicht der Ausbildungsfilm der ersten GaN-Schicht mit Si dotiert wird,
im Schritt zum Ausbilden eines Films der zweiten GaN-Schicht der Ausbildungsfilm der zweiten GaN-Schicht mit Si dotiert wird,
jede der ersten GaN-Schicht und der zweiten GaN-Schicht eine n-Typ-Leitfähigkeit hat,
eine Si-Dotierungsmitteldichte der zweiten GaN-Schicht unterschiedlich von einer Si-Dotierungsmitteldichte der ersten GaN-Schicht ist, und
eine n-Typ-Störstellenkonzentration der zweiten GaN-Schicht niedriger als eine n-Typ-Störstellenkonzentration der ersten GaN-Schicht ist, und
die n-Typ-Störstellenkonzentration eines oberen Teils der zweiten GaN-Schicht niedriger als die n-Typ-Störstellenkonzentration des unteren Teils der zweiten GaN-Schicht ist.

7. Verfahren zum Herstellen einer Halbleitervorrichtung nach Anspruch 6, das weiterhin folgendes umfasst:
einen Schritt zum Entfernen der elektrischen Leiterschicht, nachdem Filme der AlN-Schicht, der ersten GaN-Schicht, der AlₘGa₁₋ₘN-Schicht und der zweiten GaN-Schicht ausgebildet wurden, wobei
im Schritt zum Ausbilden der zweiten Elektrode die zweite Elektrode an einer Rückseite der zweiten GaN-Schicht ausgebildet wird, nachdem die elektrische Leiterschicht entfernt wurde.

8. Verfahren zum Herstellen einer Halbleitervorrichtung nach Anspruch 7, wobei
das Substrat im Schritt zum Entfernen der elektrischen Leiterschicht entfernt wird.

9. Verfahren zum Herstellen einer Halbleitervorrichtung nach Anspruch 8, wobei
im Schritt zum Entfernen der elektrischen Leiterschicht alle Schichten, die an einer Rückseite der zweiten GaN-Schicht ausgebildet sind, entfernt werden, während die zweite GaN-Schicht, die am weitesten entfernt vom Substrat ist, beibehalten wird.

## Revendications

1. Dispositif semi-conducteur comprenant :
une couche de conducteur électrique (1),
une couche SiC (2) formée sur la surface de la couche de conducteur électrique,
une couche AIN (3) formée sur la surface de la couche SiC (2), l'épaisseur de la couche AIN étant supérieure à 0 et égale ou inférieure à 15 nm,
une première couche GaN (4) d'un premier type de conductivité, formée sur la surface de la couche AIN,
une couche composite (7) formée sur la surface de la première couche GaN, et
une première électrode (9) formée sur la face supérieure de la première couche GaN, et
une seconde électrode (10), formée sur la face opposée de la couche de conducteur électrique, dans lequel l'amplitude du courant électrique circulant entre la première électrode et la seconde électrode dépend de la tension électrique entre
la première électrode et la seconde électrode,
la couche composite comprenant une couche de AlₘGa₁₋ₘN (0 < m ≤ 1, y < m) (5),
et une seconde couche GaN (6) formée sur la surface de la couche AlₘGa₁₋ₘN, la distance entre la première électrode et la couche conductrice électrique étant supérieure à la distance entre la seconde couche GaN et la couche de conducteur électrique, la première électrode étant placée en contact Schottky avec la seconde couche GaN,
chacune parmi la première couche GaN et la seconde couche GaN ayant une conductivité de type n et chacune parmi la première couche GaN et la deuxième couche GaN étant dopée avec du Si,
la densité du dopage Si de la seconde couche GaN est différente de la densité du dopage Si de la première couche GaN,
la concentration d'impuretés de type n de la seconde couche GaN est inférieure à la concentration d'impuretés de type n de la première couche GaN, et
la concentration d'impuretés de type n de la partie supérieure de la seconde couche GaN est inférieure à la concentration d'impuretés de type n de la partie inférieure de la seconde couche GaN.

2. Dispositif semi-conducteur selon la revendication 1, dans lequel
l'épaisseur de chacune parmi la première couche GaN et la seconde couche GaN est supérieure ou égale à 50 nm et égale ou inférieure à 5 µm.

3. Dispositif semi-conducteur selon la revendication 1, dans lequel l'épaisseur de la couche AlₘGa₁₋ₘN est supérieure à 0 et égale ou inférieure à 15 nm.

4. Dispositif semi-conducteur selon la revendication 1, le dispositif comprenant une pluralité de couches composites, dans lequel
un certain nombre de couches composites est supérieur à 1 et égal ou inférieur à 4 couches.

5. Dispositif semi-conducteur selon la revendication 1, dans lequel la couche de conducteur électrique est un substrat Si.

6. Procédé de fabrication d'un dispositif semi-conducteur comprenant :
l'étape de préparation d'un substrat (8) incluant une couche de conducteur électrique (1) et une couche SiC (2) formée sur la surface de la couche de conducteur électrique,
l'étape de formation d'un film de couche AIN (3) sur la surface de la couche SiC, l'épaisseur de la couche AIN étant supérieure à 0 et égale ou inférieure à 15 nm,
l'étape de formation d'un film de première couche GaN (4) d'un premier type de conductivité sur la surface de la couche AIN,
l'étape de formation d'un film de couche AlₘGa₁₋ₘN (0 < m ≤ 1, y < m) (5) sur la surface de la première couche GaN à une température inférieure à la température de formation d'un film de la première couche GaN,
l'étape de formation d'un film consistant en une seconde couche GaN (6) sur la surface de la couche AlₘGa₁₋ₘN à une température supérieure à la température de formation d'un film sur la couche de la couche AlₘGa₁₋ₘN,
l'étape de formation d'une première électrode (9) sur la surface de la seconde couche GaN, la première électrode étant placée en contact Schottky par rapport à la seconde couche GaN et,
l'étape de formation d'une seconde électrode (10) sur la face opposée de la seconde couche GaN, dans laquelle,
l'amplitude du courant électrique circulant entre la première et la seconde électrode dépend de la tension électrique entre
la première électrode et la seconde électrode
le film formé sur la première couche GaN est dopé au Si, dans l'étape de formation du film de la première couche GaN,
le film formé sur la seconde couche GaN est dopé au Si, dans l'étape de formation du film de la seconde couche GaN,
chacune parmi la première couche GaN et la seconde couche GaN a une conductivité de type n,
la densité de dopage Si de la seconde couche GaN est différente de la densité de dopage Si de la première couche GaN, et
la concentration d'impuretés de type n de la seconde couche GaN est inférieure à la concentration d'impuretés de type n de la première couche GaN, et
la concentration d'impuretés de type n de la partie supérieure de la seconde couche GaN est inférieure à la concentration d'impuretés de type n de la partie inférieure de la seconde couche GaN.

7. Procédé de fabrication d'un dispositif semi-conducteur selon la revendication 6, comprenant en outre
l'étape de retrait de la couche de conducteur électrique après la formation des films de la couche AIN, de la première couche GaN, de la couche AlₘGa₁₋ₘN et de la seconde couche GaN, dans lequel
la seconde électrode est formée sur la face opposée de la seconde couche GaN, lors de l'étape de formation de la seconde électrode, après le retrait de la couche de conducteur électrique.

8. Procédé de fabrication d'un dispositif semi-conducteur selon la revendication 7, dans lequel
le substrat est retiré lors de l'étape de retrait de la couche de conducteur électrique.

9. Procédé de fabrication d'un dispositif semi-conducteur selon la revendication 8, dans lequel
toutes les couches formées sur la face opposée de la seconde couche GaN sont retirées, en maintenant la seconde couche GaN le plus loin possible du substrat, lors de l'étape de retrait de la couche de conducteur électrique.
